# FASCICULE DE BREVET EUROPEEN

(11) **EP 3 841 654 B1**
(45) Date de publication et mention de la délivrance du brevet: **20.12.2023**
(21) Numéro de dépôt: 19753398.7
(22) Date de dépôt: 20.08.2019
(51) Int. Cl.: H02J 9/06

(54) **SYSTEME DE DETECTION D'UNE BAISSE DE TENSION D'UNE ALIMENTATION ALTERNATIVE**
SYSTEM ZUR ERKENNUNG EINES SPANNUNGSABFALLS IN EINER WECHSELSTROMVERSORGUNG
SYSTEM FOR DETECTING A VOLTAGE DROP IN AN AC POWER SUPPLY

(30) Priorité: 24.08.2018 FR 1870949
(43) Date de publication de la demande: 30.06.2021
(73) Titulaire: SAFRAN ELECTRONICS & DEFENSE, 75015 Paris (FR)
(72) Inventeur: FOURMONT, Tony, 92100 Boulogne Billancourt (FR)
(74) Mandataire: Cabinet Le Guen Maillet
(86) Numéro de dépôt international: PCT/EP2019/072225
(87) Numéro de publication internationale: WO 2020/038918

(56) Documents cités:
- US-A- 4 864 163
- US-A1- 2005 088 793
- US-A1- 2015 183 385
- US-A1- 2016 065 001
- US-A1- 2017 287 655

## Description

### DOMAINE TECHNIQUE

La présente invention concerne un système de détection d'une baisse de tension d'une alimentation alternative délivrant de l'énergie électrique à un convertisseur d'énergie afin d'alimenter un équipement électrique.

### ETAT DE LA TECHNIQUE ANTERIEURE

Les équipements électriques, tels que par exemple les équipements embarqués dans un aéronef, sont alimentés par un convertisseur d'énergie qui reçoit de l'énergie électrique par l'intermédiaire d'un bus d'alimentation électrique.

Le convertisseur d'énergie modifie la valeur de la tension d'alimentation alternative ou redresse la tension d'alimentation électrique et modifie la valeur de la tension pour fournir une alimentation en énergie électrique adaptée aux équipements électriques.

Lorsque l'alimentation en énergie s'interrompt ou son amplitude est inférieure à un seuil de fonctionnement du convertisseur d'énergie, le convertisseur d'énergie électrique ne peut plus fournir une alimentation en énergie électrique adaptée aux équipements électriques.

Des réserves d'énergie sont associées au convertisseur d'énergie pour pallier cette déficience de l'alimentation en énergie et sont commandées par un dispositif de détection d'une baisse de tension de l'alimentation en énergie électrique.

Ces réserves d'énergie dépendent des équipements à alimenter et de la durée pendant laquelle ces derniers doivent rester sous tension.

Lorsque l'alimentation en énergie électrique est une alimentation continue (en anglais Direct Current DC), il est aisé de détecter une perte totale de l'alimentation électrique ou une baisse de l'amplitude de celle-ci. Une simple comparaison de celle-ci à un seuil est suffisante et permet de commander rapidement une réserve d'énergie. Lorsque l'alimentation en énergie électrique est une alimentation alternative (en anglais Alternative Current AC), une simple comparaison d'une tension délivrée par un détecteur de crête à un seuil ne permet pas d'obtenir une détection dans une durée inférieure à une demi période de l'alimentation électrique.

La demande de brevet US 2015183385 divulgue un système de stabilisation électrique d'un aéronef.

Le brevet US4864163 divulgue une méthode de détection d'une tension AC.

### EXPOSE DE L'INVENTION

La présente invention a pour but de résoudre les inconvénients de l'art antérieur en proposant un dispositif de détection d'une baisse de tension de l'alimentation en énergie électrique qui permette de détecter, dans un délai inférieur à une demi alternance de l'alimentation électrique, une perte totale de l'alimentation électrique alternative ou une chute de la valeur de la tension de l'alimentation en énergie électrique alternative.

A cette fin, selon un premier aspect, l'invention propose un dispositif de détection d'une baisse de tension d'une alimentation alternative délivrant de l'énergie électrique à un convertisseur d'énergie afin d'alimenter un équipement électrique, le dispositif étant relié à une réserve d'énergie électrique pour alimenter le convertisseur d'énergie, caractérisé en ce que le dispositif comporte :
- un redresseur double alternance pour redresser l'alimentation alternative,
- un comparateur qui compare une première tension prédéterminée à une tension redressée double alternance obtenue d'un redresseur double alternance qui redresse l'alimentation alternative,
- un circuit de charge d'un condensateur pour charger le condensateur lorsque la tension redressée est inférieure au seuil prédéterminé,
- un circuit de décharge du condensateur pour décharger le condensateur lorsque la tension redressée est supérieure au seuil prédéterminé,
- un comparateur pour comparer la tension aux bornes du condensateur à une seconde tension prédéterminée,
- un circuit de commande de la réserve de l'énergie électrique pour activer la réserve d'énergie électrique pour la fourniture en énergie électrique du convertisseur d'énergie uniquement lorsque la tension aux bornes du condensateur est supérieure à la seconde tension prédéterminée.

Ainsi, il est possible de détecter, dans un délai inférieur à une demi alternance de l'alimentation électrique, une perte totale de l'alimentation électrique alternative ou une chute de la valeur de la tension de l'alimentation en énergie électrique alternative.

De plus, le dispositif de détection d'une baisse de tension d'une alimentation alternative comporte peu de composants électroniques et a ainsi un encombrement réduit qui facilite son utilisation dans un aéronef.

Le circuit de charge d'un condensateur pour charger le condensateur lorsque la tension redressée est inférieure au seuil prédéterminé constitue une temporisation dont la valeur est déterminée en fonction des caractéristiques de l'alimentation alternative et du convertisseur d'énergie.

Le dispositif comporte également des moyens de décalage en tension de la tension redressée double alternance lorsque la tension aux bornes du condensateur est supérieure à la seconde tension prédéterminée.

Ainsi, la détection d'une baisse de tension ou une perte totale de l'alimentation en énergie électrique est possible dans un délai inférieur à une demi alternance de l'alimentation électrique tout en évitant toute fausse détection.

Selon un mode particulier de l'invention, le dispositif comporte des moyens de décalage en tension de la seconde tension prédéterminée lorsque la première tension prédéterminée est supérieure à la tension redressée double alternance.

Ainsi, la détection est franche et stable et est robuste à des détections intempestives liées à des tensions parasites qui s'additionneraient à la tension mesurée.

Le dispositif comporte des moyens de décalage en tension de la tension redressée double alternance lorsque la tension aux bornes du condensateur est supérieure à la seconde tension prédéterminée.

Ainsi, la détection est insensible à une augmentation du niveau de la tension de l'alimentation électrique lors de variations de la consommation en énergie électrique, augmentation par exemple liée à une baisse des pertes de tension en ligne.

Selon un mode particulier de l'invention, le dispositif comporte des moyens de notification de l'équipement électrique lorsque la réserve de l'énergie électrique est commandée activée pour la fourniture en énergie électrique du convertisseur d'énergie uniquement lorsque la tension aux bornes du condensateur est supérieure à la seconde tension prédéterminée.

Ainsi, l'équipement électrique peut effectuer des opérations telles que par exemple la mémorisation de données ou l'arrêt d'un programme informatique avant que la réserve en énergie électrique soit épuisée.

L'invention concerne aussi un aéronef caractérisé en ce qu'il comporte le dispositif de détection d'une baisse de tension d'une alimentation alternative délivrant de l'énergie électrique au convertisseur d'énergie selon la présente invention.

### BREVE DESCRIPTION DES DESSINS

Les caractéristiques de l'invention mentionnées ci-dessus, ainsi que d'autres, apparaîtront plus clairement à la lecture de la description suivante d'un exemple de réalisation, ladite description étant faite en relation avec les dessins joints, parmi lesquels :
La Fig. 1 représente un système de détection d'une baisse de tension d'une alimentation alternative délivrant de l'énergie électrique à un convertisseur d'énergie afin d'alimenter un équipement électrique dans lequel la présente invention est implémentée ;
La Fig. 2 représente un exemple de l'évolution d'une alimentation alternative et la détection d'une baisse de tension d'une alimentation alternative délivrant de l'énergie électrique à un convertisseur d'énergie afin d'alimenter un équipement électrique ;
La Fig. 3 est un schéma bloc d'un module de détection d'une baisse de tension de l'alimentation en énergie électrique selon la présente invention ;
La Fig. 4 est un exemple de schéma électrique d'un dispositif de détection d'une baisse de tension de l'alimentation en énergie électrique selon la présente invention ;
La Fig. 5 représente l'évolution de différents signaux dans le module de détection d'une baisse de tension de l'alimentation en énergie électrique selon la présente invention ;
La Fig. 6 représente l'évolution de différents signaux dans le module de détection d'une baisse de tension de l'alimentation en énergie électrique lorsque qu'une perte totale de l'alimentation alternative apparaît et lorsque l'alimentation en énergie électrique revient dans une plage de fonctionnement nominale ;
La Fig. 7 représente l'évolution de différents signaux dans le module de détection d'une baisse de tension de l'alimentation en énergie électrique lorsqu'une baisse progressive de l'alimentation alternative apparaît et lorsque l'alimentation en énergie électrique revient dans une plage de fonctionnement nominale.

### EXPOSE DETAILLE DE MODES DE REALISATION

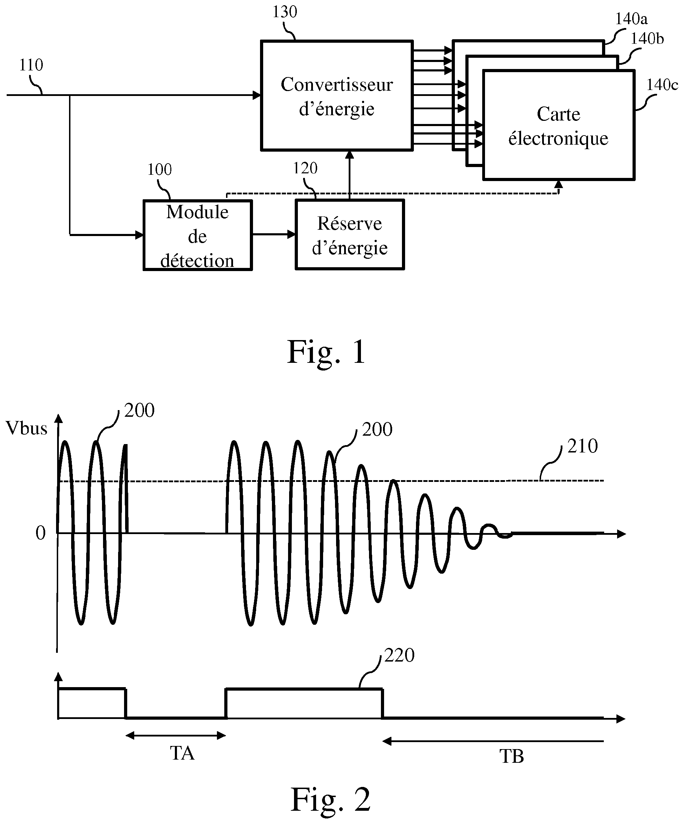

La Fig. 1 représente un système de détection d'une baisse de tension d'une alimentation alternative délivrant de l'énergie électrique à un convertisseur d'énergie afin d'alimenter un équipement électrique dans lequel la présente invention est implémentée.

Le système de détection d'une baisse de tension d'une alimentation alternative délivrant de l'énergie électrique fournie par un bus 110 comporte un convertisseur d'énergie 130 qui alimente un ou une pluralité d'équipements électriques tels que des cartes électroniques 140a, 140b et 140c.

Un équipement électrique peut par exemple être un moteur électrique.

Le système de détection d'une baisse de tension d'une alimentation alternative comporte une réserve d'énergie électrique 120 qui est activée par un module de détection 100 selon la présente invention.

Lorsque les équipements électriques sont des cartes électroniques, le module de détection 100 selon la présente invention peut être relié aux cartes électroniques 140a à 140c de manière à informer celles-ci de la perte en énergie électrique alternative, pour par exemple effectuer une sauvegarde de traitements en cours.

Le système est dans un mode particulier de la présente invention embarqué dans un aéronef.

La Fig. 2 représente un exemple de l'évolution d'une alimentation alternative et la détection d'une baisse de tension d'une alimentation alternative délivrant de l'énergie électrique à un convertisseur d'énergie afin d'alimenter un équipement électrique.

La tension de l'alimentation en énergie électrique du bus 110 est notée 200.

Le signal en sortie du module de détection 100 est noté 220 en Fig. 2.

Lorsque l'alimentation en énergie électrique du bus 110 est rompue, le module de détection 100 détecte celle-ci pendant la durée TA.

Lorsque la tension de l'alimentation en énergie électrique du bus 110 devient inférieure à un seuil de fonctionnement du convertisseur d'énergie 130, le module de détection 100 détecte celle-ci pendant la durée TB.

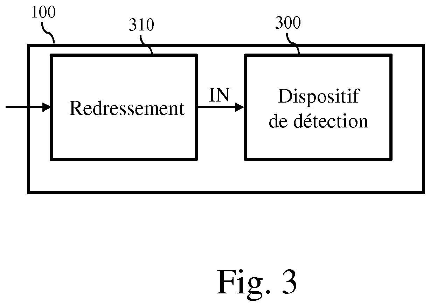

La Fig. 3 est un schéma bloc d'un module de détection d'une baisse de tension de l'alimentation en énergie électrique selon la présente invention.

Le module de détection d'une baisse de tension de l'alimentation en énergie électrique 100 comporte un dispositif de redressement double alternance 310 qui fournit un signal IN redressé au dispositif de détection d'une baisse de tension de l'alimentation en énergie électrique 300.

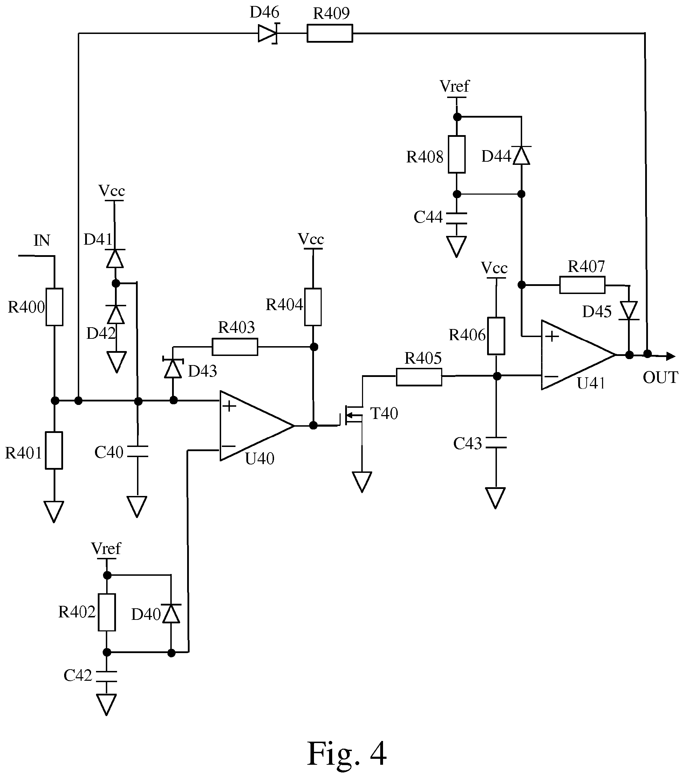

La Fig. 4 est un exemple de schéma électrique d'un dispositif de détection d'une baisse de tension de l'alimentation en énergie électrique selon la présente invention.

L'entrée IN du dispositif de détection d'une baisse de tension de l'alimentation en énergie électrique est reliée à une première terminaison d'une résistance R400. Une seconde terminaison de la résistance R400 est reliée à une première terminaison d'une résistance R401, l'anode d'une diode Zener D43, à une première terminaison d'un condensateur C40 et à une entrée positive d'un comparateur U40.

Une seconde terminaison de la résistance R401 est reliée à la masse d'une alimentation continue Vcc.

Une seconde terminaison du condensateur C40 est reliée à la masse.

Les résistances R400 et R401 forment un pont diviseur de tension de la tension alternative redressée présente sur l'entrée IN.

Une cathode d'une diode D42 est reliée à une anode d'une diode D41 et à l'entrée positive du comparateur U40.

L'anode de la diode D42 est reliée à la masse et la cathode de la diode D41 est reliée à l'alimentation Vcc. Les diodes D41 et D42 ont pour fonction de protéger l'entrée du comparateur U40.

Lorsque l'entrée du comparateur U40 n'a pas besoin d'être protégée, les diodes D41 et D42 peuvent être supprimées.

Une première terminaison d'une résistance R402 est reliée à une référence de tension Vref, dont la valeur est par exemple de 2.048V et à une cathode d'une diode D40.

Une seconde terminaison de la résistance R402 est reliée à une première terminaison d'un condensateur C42, à l'anode de la diode D40 et à une entrée négative du comparateur U40.

Une seconde terminaison du condensateur C42 est reliée à la masse.

Ce dispositif permet d'éviter des déclenchements intempestifs lors de la mise sous tension du système lorsque les tensions d'alimentation internes du dispositif de détection ne sont pas encore stabilisées.

La référence de tension Vref, la résistance R402, le condensateur C42 et la diode D40 donnent une tension constante sur l'entrée négative du comparateur U40.

La sorte du comparateur U40 est reliée à la grille d'un transistor T40, à une première terminaison d'une résistance R403 et à une première terminaison d'une résistance R404.

Une seconde terminaison de la résistance R403 est reliée à la cathode de la diode Zener D43 et une seconde terminaison de la résistance R404 est reliée à l'alimentation Vcc qui alimente le comparateur U40.

Lorsque la tension sur l'entrée positive à l'entrée du comparateur U40 est supérieure à la tension sur l'entrée négative du comparateur U40, la sortie du comparateur U40 est au niveau haut et sature le transistor T40.

Lorsque la tension sur l'entrée positive à l'entrée du comparateur U40 est inférieure à la tension sur l'entrée négative du comparateur U40, la sortie du comparateur U40 est au niveau bas, bloque le transistor T40.

Une tension d'hystérésis apparaît alors sur l'entrée positive du comparateur U40.

Les résistances R403, R404 et la diode D43 forment la tension d'hystérésis.

La source du transistor T40 est reliée à la masse et le drain du transistor T40 est relié à une première terminaison d'une résistance R405.

Une seconde terminaison de la résistance R405 est reliée à une première terminaison d'un condensateur C43, à une première terminaison d'une résistance R406 et à une entrée négative d'un comparateur U41.

Une seconde terminaison de la résistance R406 est reliée à l'alimentation Vcc qui alimente le comparateur UR41.

Une seconde terminaison du condensateur C43 est reliée à la masse.

Une première terminaison d'une résistance R408 est reliée à la référence de tension Vref et à une cathode d'une diode D44.

La référence de tension est par exemple de 2.048V, elle pourrait être tout autre dans une autre application, moyennant une adaptation de la constante de temps issue de R405 et C43.

Une seconde terminaison de la résistance R408 est reliée à une première terminaison d'un condensateur C44, à l'anode de la diode D44, à une première terminaison d'une résistance R407 et à une entrée négative du comparateur U40.

Une seconde terminaison du condensateur C44 est reliée à la masse.

La référence de tension Vref, la résistance R408, le condensateur C44 et la diode D44 donnent une tension constante sur l'entrée positive du comparateur U41.

Une seconde terminaison de la résistance R407 est reliée à l'anode d'une diode D45 dont la cathode est reliée à la sortie du comparateur U41.

Lorsque le transistor T40 conduit, le condensateur C43 est déchargé par l'intermédiaire de la résistance R405 de faible valeur.

Lorsque le transistor T40 est bloqué, le condensateur C43 se charge par l'intermédiaire de la résistance R406.

Lorsque la tension aux bornes du condensateur C43 est inférieure à la tension sur l'entrée positive du comparateur U41, la sortie du comparateur U41 est à l'état haut.

Lorsque la tension aux bornes du condensateur C43 est supérieure à la tension sur l'entrée positive du comparateur U41, la sortie du comparateur U41 est à l'état bas, la diode D45 conduit et une hystérésis apparaît sur l'entrée positive du comparateur U41.

Cette hystérésis de très forte valeur permet de verrouiller le basculement de la sortie du comparateur U41 dont le déclenchement a été provoqué par le dépassement de la temporisation définie par R406 et C43.

La sortie du comparateur U41 est reliée à la sortie OUT du dispositif de détection d'une baisse de tension de l'alimentation en énergie électrique et à une première terminaison d'une résistance R409. Une seconde terminaison de la résistance R409 est reliée à une cathode d'une diode D46.

L'anode de la diode D46 est reliée à l'entrée positive du comparateur U40.

La résistance R409 et la diode D46 forment une hystérésis lorsque la sortie du comparateur U41 est à l'état bas.

L'hystérésis ainsi produite permet de verrouiller l'ensemble de la chaîne de détection d'une baisse de tension d'alimentation en énergie électrique dès que l'évènement se produit.

Le déverrouillage se produit lorsque la tension d'entrée IN revient dans la plage de fonctionnement normal c'est-à-dire en appliquant une tension sur l'entrée plus du comparateur U40 au-delà de l'hystérésis créée par R409 et D46.

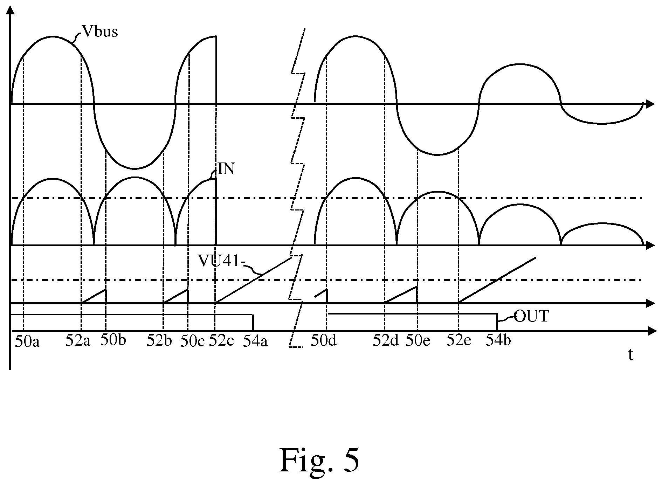

La Fig. 5 représente l'évolution de différents signaux dans le module de détection d'une baisse de tension de l'alimentation en énergie électrique selon la présente invention.

Dans la Fig. 5, sont représentées la tension Vbus, la tension IN en entrée du dispositif de détection d'une baisse de tension de l'alimentation en énergie électrique, la tension OUT en sortie du dispositif de détection d'une baisse de tension de l'alimentation en énergie électrique et la tension VU41- présente sur l'entrée négative du comparateur U41.

A l'instant 50a, la tension IN est supérieure à la valeur minimale de fonctionnement du convertisseur d'énergie 130, le transistor T40 de la Fig. 4 est saturé et le condensateur C43 est déchargé. La sortie OUT est à l'état haut et la réserve d'énergie n'est pas activée.

A l'instant 52a, la tension IN est inférieure à la valeur minimale de fonctionnement du convertisseur d'énergie 130, le transistor T40 de la Fig. 4 est bloqué et le condensateur C43 se charge jusqu'à l'instant 50b et la valeur à l'entrée négative du comparateur U41 est inférieure à la tension sur l'entrée positive du comparateur UR1, la sortie OUT reste à l'état haut et la réserve d'énergie n'est pas activée.

A l'instant 50b, la tension IN est supérieure à la valeur minimale de fonctionnement du convertisseur d'énergie 130, le transistor T40 de la Fig. 4 est saturé et le condensateur C43 se décharge, la valeur à l'entrée négative du comparateur U41 est inférieure à la tension sur l'entrée positive du comparateur UR1, la sortie OUT reste à l'état haut et la réserve d'énergie n'est pas activée.

A l'instant 52b, la tension IN est inférieure à la valeur minimale de fonctionnement du convertisseur d'énergie 130, le transistor T40 de la Fig. 4 est bloqué et le condensateur C43 se charge jusqu'à l'instant 50c et la valeur à l'entrée négative du comparateur U41 est inférieure à la tension sur l'entrée positive du comparateur UR1, la sortie OUT reste à l'état haut et la réserve d'énergie n'est pas activée.

A l'instant 50c, la tension IN est supérieure à la valeur minimale de fonctionnement du convertisseur d'énergie 130, le transistor T40 de la Fig. 4 est saturé et le condensateur C43 se décharge, la valeur à l'entrée négative du comparateur U41 est inférieure à la tension sur l'entrée positive du comparateur UR1, la sortie OUT reste à l'état haut et la réserve d'énergie n'est pas activée.

A l'instant 52c, la tension IN est inférieure à la valeur minimale de fonctionnement du convertisseur d'énergie 130, le transistor T40 de la Fig. 4 est bloqué et le condensateur C43 se charge jusqu'à l'instant 54a et la valeur à l'entrée négative du comparateur U41 est supérieure à la tension sur l'entrée positive du comparateur UR1, la sortie OUT passe à l'état bas et la réserve d'énergie est activée.

A l'instant 50d, la tension IN est supérieure à la valeur minimale de fonctionnement du convertisseur d'énergie 130, le transistor T40 de la Fig. 4 est saturé et le condensateur C43 se décharge, la valeur à l'entrée négative du comparateur U41 est inférieure à la tension sur l'entrée positive du comparateur UR1, la sortie OUT reste à l'état haut et la réserve d'énergie n'est pas activée.

A l'instant 52d, la tension IN est inférieure à la valeur minimale de fonctionnement du convertisseur d'énergie 130, le transistor T40 de la Fig. 4 est bloqué et le condensateur C43 se charge jusqu'à l'instant 50e et la valeur à l'entrée négative du comparateur U41 est inférieure à la tension sur l'entrée positive du comparateur UR1, la sortie OUT reste à l'état haut et la réserve d'énergie n'est pas activée.

A l'instant 50e, la tension IN est supérieure à la valeur minimale de fonctionnement du convertisseur d'énergie 130, le transistor T40 de la Fig. 4 est saturé et le condensateur C43 se décharge, la valeur à l'entrée négative du comparateur U41 est inférieure à la tension sur l'entrée positive du comparateur UR1, la sortie OUT reste à l'état haut et la réserve d'énergie n'est pas activée.

A l'instant 52e, la tension IN est inférieure à la valeur minimale de fonctionnement du convertisseur d'énergie 130, le transistor T40 de la Fig. 4 est bloqué et le condensateur C43 se charge jusqu'à l'instant 54b et la valeur à l'entrée négative du comparateur U41 est supérieure à la tension sur l'entrée positive du comparateur UR1, la sortie OUT passe à l'état bas et la réserve d'énergie est activée.

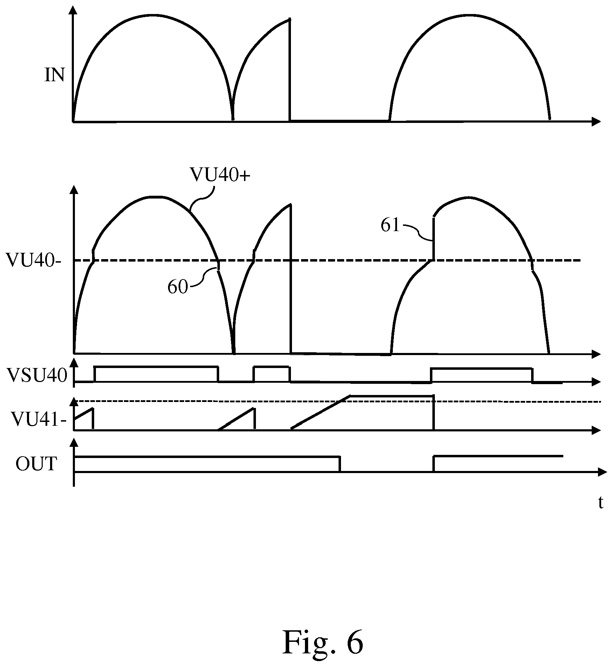

La Fig. 6 représente l'évolution de différents signaux dans le module de détection d'une baisse de tension de l'alimentation en énergie électrique lorsqu'une perte totale de l'alimentation alternative apparaît et lorsque l'alimentation en énergie électrique revient dans une plage de fonctionnement nominale.

Dans la Fig. 6, sont représentées la tension IN en entrée du dispositif de détection d'une baisse de tension de l'alimentation en énergie électrique, la tension OUT en sortie du dispositif de détection d'une baisse de tension de l'alimentation en énergie électrique, la tension VU40- sur l'entrée négative du comparateur U40, la tension VU40+ sur l'entrée positive négative du comparateur U40, la tension SU40 en sortie du comparateur U40 et la tension VU41- présente sur l'entrée négative du comparateur U41.

L'hystérésis 60 est provoquée par la conduction de la diode D43.

L'hystérésis 61 est provoquée par la conduction des diodes D45 et D46.

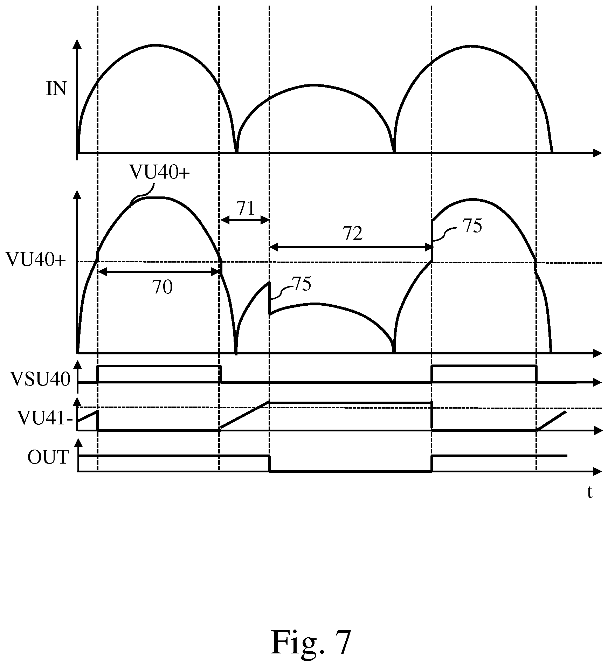

La Fig. 7 représente l'évolution de différents signaux dans le module de détection d'une baisse de tension de l'alimentation en énergie électrique lorsqu'une baisse progressive de l'alimentation alternative apparaît et lorsque l'alimentation en énergie électrique revient dans une plage de fonctionnement nominale.

Dans la Fig. 7, sont représentées la tension IN en entrée du dispositif de détection d'une baisse de tension de l'alimentation en énergie électrique, la tension OUT en sortie du dispositif de détection d'une baisse de tension de l'alimentation en énergie électrique, la tension VU40- sur l'entrée négative du comparateur U40, la tension VU40+ sur l'entrée positive négative du comparateur U40, la tension SU40 en sortie du comparateur U40 et la tension VU41- présente sur l'entrée négative du comparateur U41.

Pendant la période notée 70, la tension sur l'entrée positive à l'entrée du comparateur U40 est supérieure à la tension sur l'entrée négative du comparateur U40, la sortie du comparateur U40 est au niveau haut et sature le transistor T40 et une tension d'hystérésis apparaît sur l'entrée positive du comparateur U40.

Pendant la période notée 71, la tension sur l'entrée positive à l'entrée du comparateur U40 est inférieure à la tension sur l'entrée négative du comparateur U40, la sortie du comparateur U40 est au niveau bas, bloque le transistor T40.

Pendant la période notée 72, la tension aux bornes du condensateur C43 est supérieure à la tension sur l'entrée positive du comparateur U41, la sortie du comparateur U41 est à l'état bas, la diode D45 conduit et une hystérésis apparaît sur l'entrée positive du comparateur U41 ; la diode D46 conduit également et une hystérésis 80 apparaît sur l'ensemble de la chaîne de détection.

## Revendications

1. Dispositif de détection (100) d'une baisse de tension d'une alimentation alternative (110) délivrant de l'énergie électrique à un convertisseur d'énergie (130) afin d'alimenter un équipement électrique (140a, 140b, 140c), le dispositif (100) étant relié à une réserve d'énergie électrique (120) pour alimenter le convertisseur d'énergie, **caractérisé en ce que** le dispositif (100) comporte :
- un redresseur double alternance pour redresser l'alimentation alternative,
- un comparateur qui compare une première tension prédéterminée à une tension redressée double alternance obtenue du redresseur double alternance qui redresse l'alimentation alternative,
- un circuit de charge d'un condensateur pour charger le condensateur lorsque la tension redressée est inférieure à la première tension prédéterminée,
- un circuit de décharge du condensateur pour décharger le condensateur lorsque la tension redressée est supérieure à la première tension prédéterminée,
- un comparateur pour comparer la tension aux bornes du condensateur à une seconde tension prédéterminée,
- un circuit de commande de la réserve de l'énergie électrique pour activer la réserve d'énergie électrique pour la fourniture en énergie électrique du convertisseur d'énergie uniquement lorsque la tension aux bornes du condensateur est supérieure à la seconde tension prédéterminée,
- des moyens de décalage en tension de la tension redressée double alternance lorsque la tension aux bornes du condensateur est supérieure à la seconde tension prédéterminée.

2. Dispositif selon la revendication 1, **caractérisé en ce que** le dispositif (100) comporte des moyens de décalage en tension de la seconde tension prédéterminée lorsque la première tension prédéterminée est supérieure à la tension redressée double alternance.

3. Dispositif selon l'une quelconque des revendications 1 à 2, **caractérisé en ce que** le dispositif (100) comporte des moyens de notification de l'équipement électrique lorsque la réserve de l'énergie électrique est commandée activée pour la fourniture en énergie électrique du convertisseur d'énergie uniquement lorsque la tension aux bornes du condensateur est supérieure à la seconde tension prédéterminée.

4. Aéronef **caractérisé en ce qu'**il comporte le dispositif (100) de détection d'une baisse de tension d'une alimentation alternative délivrant de l'énergie électrique au convertisseur d'énergie selon l'une quelconque des revendications 1 à 3.

## Patentansprüche

1. Erkennungsvorrichtung (100) eines Spannungsabfalls einer Wechselstromversorgung (110), die elektrische Energie an einen Energiewandler (130) liefert, um eine elektrische Ausrüstung (140a, 140b, 140c) zu versorgen, wobei die Vorrichtung (100) mit einer Reserve elektrischer Energie (120) verbunden ist, um den Energiewandler zu versorgen, **dadurch gekennzeichnet, dass** die Vorrichtung (100) aufweist:
- einen Zweiphasengleichrichter, um die Wechselstromversorgung gleichzurichten,
- einen Komparator, der eine erste vorbestimmte Spannung mit einer gleichgerichteten Zweiphasenspannung vergleicht, die vom Zweiphasengleichrichter erhalten wird, der die Wechselstromversorgung gleichrichtet,
- eine Ladeschaltung eines Kondensators, um den Kondensator zu laden, wenn die gleichgerichtete Spannung niedriger ist als die vorbestimmte erste Spannung,
- eine Entladeschaltung des Kondensators, um den Kondensator zu entladen, wenn die gleichgerichtete Spannung höher ist als die vorbestimmte erste Spannung,
- einen Komparator, um die Spannung an den Klemmen des Kondensators mit einer vorbestimmten zweiten Spannung zu vergleichen,
- eine Steuerschaltung der Reserve der elektrischen Energie, um die Reserve eklektischer Energie für die Versorgung des Energiewandlers mit elektrischer Energie nur zu aktivieren, wenn die Spannung an den Klemmen des Kondensators höher ist als die vorbestimmte zweite Spannung,
- Spannungsoffset-Einrichtungen der gleichgerichteten Zweiphasenspannung, wenn die Spannung an den Klemmen des Kondensators höher ist als die vorbestimmte zweite Spannung.

2. Vorrichtung nach Anspruch 1, **dadurch gekennzeichnet, dass** die Vorrichtung (100) Spannungsoffset-Einrichtungen der vorbestimmten zweiten Spannung aufweist, wenn die vorbestimmte erste Spannung höher ist als die gleichgerichtete Zweiphasenspannung.

3. Vorrichtung nach einem der Ansprüche 1 bis 2, **dadurch gekennzeichnet, dass** die Vorrichtung (100) Einrichtungen zur Benachrichtigung der elektrischen Ausrüstung aufweist, wenn der Reserve der elektrischen Energie für die Lieferung elektrischer Energie an den Energiewandler nur aktiviert gesteuert wird, wenn die Spannung an den Klemmen des Kondensators höher ist als die vorbestimmte zweite Spannung.

4. Luftfahrzeug, **dadurch gekennzeichnet, dass** es die Vorrichtung (100) zur Erkennung eines Spannungsabfalls einer Wechselstromversorgung aufweist, die elektrische Energie an den Energiewandler nach einem der Ansprüche 1 bis 3 liefert.

## Claims

1. Device (100) for detecting a voltage drop in an AC power supply (110) delivering electrical energy to an energy converter (130) in order to supply power to an item of electrical equipment (140a, 140b, 140c), the device (100) being connected to an electrical energy store (120) to supply power to the energy converter, **characterized in that** the device (100) comprises:
- a full-wave rectifier for rectifying the AC power supply,
- a comparator that compares a first predetermined voltage with a full-wave rectified voltage obtained from the full-wave rectifier that rectifies the AC power supply,
- a capacitor charging circuit for charging the capacitor when the rectified voltage is lower than the first predetermined voltage,
- a capacitor discharging circuit for discharging the capacitor when the rectified voltage is greater than the first predetermined voltage,
- a comparator for comparing the voltage across the terminals of the capacitor with a second predetermined voltage,
- a circuit for controlling the electrical energy store to activate the electrical energy store to provide electrical energy from the energy converter only when the voltage across the terminals of the capacitor is greater than the second predetermined voltage,
- means for voltage-shifting the full-wave rectified voltage when the voltage across the terminals of the capacitor is greater than the second predetermined voltage.

2. Device according to Claim 1, **characterized in that** the device (100) comprises means for voltage-shifting the second predetermined voltage when the first predetermined voltage is greater than the full-wave rectified voltage.

3. Device according to either of Claims 1 and 2, **characterized in that** the device (100) comprises means for notifying the item of electrical equipment when the electrical energy store is controlled to the activated state to provide electrical energy from the energy converter only when the voltage across the terminals of the capacitor is greater than the second predetermined voltage.

4. Aircraft, **characterized in that** it comprises the device (100) for detecting a voltage drop in an AC power supply delivering electrical energy to the energy converter according to any one of Claims 1 to 3.
